(19) Europäisches Patentamt
European Patent Office
Office européen des brevets

(11) EP 4 502 092 A1

(12) EUROPEAN PATENT APPLICATION
published in accordance with Art. 153(4) EPC

(43) Date of publication:
**05.02.2025 Bulletin 2025/06**

(21) Application number: **23774833.0**

(22) Date of filing: **17.03.2023**

(51) International Patent Classification (IPC):
***C09J 4/00*** *(2006.01)* ***C09J 201/06*** *(2006.01)*
***H01L 21/02*** *(2006.01)*

(52) Cooperative Patent Classification (CPC):
**C09J 4/00; C09J 201/06; H01L 21/02**

(86) International application number:
**PCT/JP2023/010737**

(87) International publication number:
**WO 2023/182238 (28.09.2023 Gazette 2023/39)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **24.03.2022 JP 2022049032**

(71) Applicant: **Daicel Corporation**
**Osaka-shi, Osaka 530-0011 (JP)**

(72) Inventor: **TSUJI, Naoko**
**Tokyo 108-8230 (JP)**

(74) Representative: **Grünecker Patent- und Rechtsanwälte**
**PartG mbB**
**Leopoldstraße 4**
**80802 München (DE)**

# (54) TEMPORARY ADHESIVE, AND METHOD FOR MANUFACTURING SEMICONDUCTOR WAFER LAMINATE USING THE TEMPORARY ADHESIVE

(57) Provided is a temporary adhesive that has good applicability and adhesiveness and allows an adherend to be easily peeled off by a slide peeling method or a blade peeling method. The temporary adhesive of the present disclosure contains, as resin components, a polyvalent vinyl ether compound (A), a polymer (B) having a plurality of hydroxy groups and/or carboxy groups as pendant groups, and a thermoplastic resin (C). The polymer (B) has a weight average molecular weight from 1500 to 7000, the thermoplastic resin (C) has a weight average molecular weight greater than 7000, and the resin components contained in the temporary adhesive have a weight average molecular weight less than or equal to 100000. A weight average molecular weight of the resin components contained in a heat-treated product formed by heating the temporary adhesive at 230°C for 5 minutes is more than or equal to 1.2 times as great as the weight average molecular weight of the resin components contained in the temporary adhesive, the heat-treated product has a Tg higher than or equal to 100°C and lower than 200°C, and the heat-treated product has a viscosity, at 200°C and a frequency of 10 Hz, of less than or equal to 100 cP.



Processed by Luminess, 75001 PARIS (FR)

## Description

### Technical Field

The present disclosure relates to a temporary adhesive used for temporarily fixing an adherend such as a semiconductor wafer, and a method for manufacturing a semiconductor wafer laminate using the temporary adhesive. The present disclosure claims priority from JP 2022-049032 filed in Japan on March 24, 2022, the contents of which are incorporated herein by reference.

### Background Art

Miniaturization, thinning, and three dimensional integration of semiconductor chips have been advanced for realizing miniaturization and function improvement of electronic devices, efficiency improvement of power consumption, and the like. Such a semiconductor chip is manufactured by forming a circuit pattern on a wafer, grinding and thus thinning the wafer, and dicing the wafer. However, the thinned wafer is very fragile, and thus is easily damaged when subjected to processing such as grinding and dicing, when transported, and the like. Therefore, the wafer is processed and transported in a state where the wafer is protected by being temporarily fixed to a support.

Then, upon completion of processing, transportation, and the like, the wafer is peeled off from the support. As a wafer peeling method, there are known a slide peeling method in which a wafer is slid and peeled off after a viscosity of a temporary adhesive is reduced by heating, a blade peeling method in which a blade is inserted into an interface between a wafer and a temporary adhesive, and the wafer is mechanically peeled off, and the like. A temporary adhesive is selected and used according to the peeling method.

For example, a wax type temporary adhesive has been used in the slide peeling method (for example, Patent Document 1).

The wax type temporary adhesive has strong tackiness. Thus, when the temporary adhesive is used in the blade peeling method, its adhesive component tends to adhere to the blade, and it is very difficult to remove the adhered adhesive component. In addition, the wax type temporary adhesive has a low softening point. Thus, the viscosity of the temporary adhesive decreases in a high temperature environment, and it is unfortunately difficult to fix the wafer to the support.

On the other hand, in the blade peeling method, a curable type temporary adhesive has been used (for example, Patent Document 2). Once the curing type temporary adhesive is cured, the viscosity thereof cannot be reduced even by heating thereafter, and therefore the temporary adhesive cannot be used in the slide peeling method.

That is, temporary adhesives that can be used in both the slide peeling method and the blade peeling method have not been known.

### Citation List

### Patent Document

Patent Document 1: JP 2008-49443 A
Patent Document 2: WO 2021/112070

### Summary of Invention

### Technical Problem

Accordingly, an object of the present disclosure is to provide a temporary adhesive which has good applicability and adhesiveness, can satisfactorily adhere an adherend to a support or the like not only at room temperature but also in a high temperature environment, and allows the adherend to be peeled off from the support or the like by a slide peeling method or a blade peeling method without damaging the adherend.

Another object of the present disclosure is to provide a temporary adhesive which has good applicability and adhesiveness, can satisfactorily adhere an adherend to a support or the like not only at room temperature but also in a high temperature environment, and allows the adherend to be peeled off from the support or the like by a slide peeling method or a blade peeling method without damaging the adherend and without adhesive residues.

Still another object of the present disclosure is to provide a method for manufacturing a semiconductor wafer laminate using the temporary adhesive.

Solution to Problem

As a result of intensive studies for solving the above issues, the present inventor has found: that a temporary adhesive having a structure as will be described below contains resin components having a weight average molecular weight less than or equal to 100000, and thus has a low viscosity and excellent applicability; that, when the temporary adhesive as will be described below is subjected to a heat treatment, the molecular weight of its resin components increases by more than or equal to 1.2 times as compared with that before the heat treatment, and thus exhibits good adhesiveness even in a high temperature environment; that the temporary adhesive after the heat treatment (referred to as "heat-treated product") has a Tg in a temperature region higher than or equal to 100°C and lower than 200°C, and thus blade peeling can be easily performed at a temperature lower than or equal to 30°C; and that, when the heat-treated product is heated at a temperature higher than or equal to 200°C, a viscosity thereof is less than or equal to 100 cP, and, therefore, slide peeling can be easily performed, and adhesive residues after slide peeling can be easily removed by washing or the like.

The present disclosure has been completed based on these findings.

That is, the present disclosure provides a temporary adhesive containing, as resin components, a polyvalent vinyl ether compound (A), a polymer (B) having a plurality of hydroxy groups and/or carboxy groups as pendant groups, and a thermoplastic resin (C),
wherein

the polymer (B) has a weight average molecular weight (calibrated with polystyrene by a GPC method) from 1500 to 7000,
the thermoplastic resin (C) has a weight average molecular weight (calibrated with polystyrene by the GPC method) greater than 7000,
the resin components contained in the temporary adhesive have a weight average molecular weight less than or equal to 100000,
a weight average molecular weight of resin components contained in a heat-treated product formed by heating the temporary adhesive at 230°C for 5 minutes is 1.2 times or more the weight average molecular weight of the resin components contained in the temporary adhesive,
the heat-treated product has a Tg higher than or equal to 100°C and lower than 200°C, and
the heat-treated product has a viscosity, at 200°C and a frequency of 10 Hz, less than or equal to 100 cP.

The present disclosure also provides the temporary adhesive containing the polyvalent vinyl ether compound (A) and the polymer (B) such that a molar ratio of a vinyl ether group contained in the polyvalent vinyl ether compound (A) to a total of the hydroxy groups and the carboxy groups contained in the polymer (B) (former/latter) is in a range from 0.1 to 10.

The present disclosure also provides a method for manufacturing a semiconductor wafer laminate, the semiconductor wafer laminate being formed through [1] to [5] or [1] to [4] and [6], the method including:

[1] applying the temporary adhesive as described above to at least one of a first semiconductor wafer or a support, and bonding the first semiconductor wafer and the support to each other, thereby forming a laminate 1 having a structure [first semiconductor wafer/temporary adhesive/support];
[2] heating the laminate 1, and allowing a crosslinking reaction of resin components in the temporary adhesive to proceed until a weight average molecular weight of the resin components increases by more than or equal to 1.2 times, thereby forming a laminate 2 having a structure [first semiconductor wafer/temporary adhesive layer/support];
[3] processing the first semiconductor wafer of the laminate 2, thereby forming a laminate 3 having a structure [processed first semiconductor wafer/temporary adhesive layer/support];
[4] bonding a second semiconductor wafer to the laminate 3 via a permanent adhesive, and curing the permanent adhesive, thereby forming a laminate 4 having a structure [second semiconductor wafer/permanent adhesive layer/processed first semiconductor wafer/temporary adhesive layer/support];
[5] heating the laminate 4 until a viscosity, at a frequency of 10 Hz, of the temporary adhesive layer reaches less than or equal to 100 cP, and slide-peeling off the support, thereby forming a semiconductor wafer laminate having a structure [second semiconductor wafer/permanent adhesive layer/processed first semiconductor wafer]; and
[6] in an atmosphere at a temperature lower than or equal to 30°C, inserting a blade into a gap between the processed first semiconductor wafer and the support of the laminate 4, and peeling off the support, thereby forming a semiconductor wafer laminate having a structure [second semiconductor wafer/permanent adhesive layer/processed first semiconductor wafer].

## Advantageous Effects of Invention

The temporary adhesive of the present disclosure has the above-described configuration, and thus has good applicability at room temperature and can form a coating film having a uniform thickness with a high yield. When the temporary adhesive is subjected to a heat treatment, the resin components in the temporary adhesive have an increased molecular weight and exhibit excellent adhesiveness even in a high temperature environment.

A heat-treated product formed by subjecting the temporary adhesive to a heat treatment has a Tg higher than or equal to 100°C and lower than 200°C. Therefore, in a temperature environment at a temperature lower than or equal to 30°C, it is a glassy solid and does not have tackiness. Therefore, a semiconductor wafer adhered to a support with the temporary adhesive can be easily peeled off from a support by a blade peeling method in a temperature environment at a temperature lower than or equal to 30°C.

Further, the heat-treated product has thermoplasticity, and a viscosity thereof can be reduced to less than or equal to 100 cP by heating it at a temperature higher than or equal to 200°C. Therefore, the semiconductor wafer adhered to the support with the temporary adhesive, when heated at a temperature higher than or equal to 200°C, can be easily peeled off from a support by a slide peeling method.

An adhesive residue of the heat-treated product remaining on a surface of the semiconductor wafer after peeling can be easily dissolved and removed by washing with a solvent.

Therefore, the temporary adhesive of the present disclosure can be suitably used as an adhesive for temporarily fixing (or transiently fixing) a fragile adherend. When it is no longer necessary to temporarily fix the adherend, the adherend can be easily released from the fixed state without damaging the adherend (even if the adherend is fragile, without damaging the fragile adherend) by either of the blade peeling method and the slide peeling method. Therefore, the temporary adhesive can be suitably used in the manufacture of a semiconductor wafer laminate.

## Description of Embodiments

### Temporary Adhesive

The temporary adhesive of the present disclosure contains, as resin components, a polyvalent vinyl ether compound (A) (hereinafter sometimes referred to as "compound (A)"), a polymer (B) having a plurality of hydroxy groups and/or carboxy groups as pendant groups (hereinafter sometimes referred to as "polymer (B)"), and a thermoplastic resin (C), which will be described later.

The temporary adhesive is used for temporarily fixing an adherend. The adherend is adhered (or fixed) to a support or the like, and, when it becomes unnecessary to adhere (or fix) the adherend, the adherend can be released from the state of being adhered (or fixed) to the support.

A weight average molecular weight of the resin components contained in the temporary adhesive is less than or equal to 100000, and is preferably less than or equal to 80000, and particularly preferably less than or equal to 30000 from the viewpoint of excellent applicability. In addition, the weight average molecular weight is, for example, greater than or equal to 5000, and is preferably less than or equal to 8000 from the viewpoint of having a property (= adhesiveness) of favorably adhering (or fixing) an adherend to a support or the like in a high temperature environment after heat treatment.

When the temporary adhesive is heated at 230°C for 5 minutes, a heat-treated product containing a crosslinked body of the compound (A) and the polymer (B) together with the thermoplastic resin (C) is formed. A weight average molecular weight of the resin components contained in the heat-treated product is more than or equal to 1.2 times as great as the weight average molecular weight of the resin components contained in the temporary adhesive before heating, and is preferably more than or equal to 1.25 times from the viewpoint of achieving stronger adhesiveness in a high temperature environment. In addition, the weight average molecular weight of the resin components contained in the heat-treated product is preferably less than or equal to 2.5 times, particularly preferably less than or equal to 2.0 times, and most preferably less than or equal to 1.50 times as great as the weight average molecular weight of the resin components contained in the temporary adhesive from the viewpoint of providing good peelability (particularly, good peelability by a slide peeling method).

The weight average molecular weight of the resin components contained in the heat-treated product is, for example, greater than or equal to 5000, and is preferably greater than or equal to 6000, more preferably greater than or equal to 7000, particularly preferably greater than or equal to 8000, most preferably greater than or equal to 10000, and especially preferably greater than or equal to 12000 from the viewpoint that their softening point is increased and stronger adhesiveness can be exhibited in a high temperature environment. An upper limit value of the weight average molecular weight is, for example, 20000, preferably 16000, particularly preferably 15000, and most preferably 14000.

The softening point of the resin components contained in the heat-treated product is, for example, higher than or equal to 110°C, preferably higher than or equal to 120°C, particularly preferably higher than or equal to 125°C, and most preferably higher than or equal to 130°C. An upper limit value of the softening point is, for example, 200°C.

In addition, a Tg of the heat-treated product is higher than or equal to 100°C and lower than 200°C, and is preferably from 100 to 150°C, particularly preferably from 105 to 130°C, and most preferably from 110 to 120°C from the viewpoint of providing good peelability (particularly good peelability by a blade peeling method at a temperature less than or equal to 30°C).

Furthermore, a viscosity, at 200°C and a frequency of 10 Hz, of the heat-treated product is less than or equal to 100 cP, and is preferably less than or equal to 70 cP, particularly preferably less than or equal to 50 cP, most preferably less than or equal to 40 cP, and especially preferably less than or equal to 35 cP from the viewpoint of providing good peelability (particularly good peelability by a slide peeling method). A lower limit value of the viscosity is, for example, 10 cP and preferably 20 cP.

A content of the compound (A) is, for example, from 0.5 to 10 wt.%, preferably from 0.5 to 5 wt.%, particularly preferably from 1 to 5 wt.%, and most preferably from 1 to 3 wt.% based on a total amount of non-volatile components of the temporary adhesive.

A content of the polymer (B) is, for example, from 5 to 60 wt.%, preferably from 10 to 55 wt.%, more preferably from 10 to 50 wt.%, particularly preferably from 20 to 45 wt.%, most preferably from 25 to 40 wt.%, and especially preferably from 30 to 40 wt.% based on the total amount of the non-volatile components of the temporary adhesive.

A content of the thermoplastic resin (C) is, for example, from 35 to 75 wt.%, preferably from 40 to 75 wt.%, preferably from 45 to 70 wt.%, particularly preferably from 45 to 65 wt.%, and most preferably from 50 to 60 wt.% based on the total amount of the non-volatile components of the temporary adhesive.

Regarding the contents of the compound (A) and the polymer (B), a molar ratio of a vinyl ether group contained in the compound (A) to a total of the hydroxy groups and the carboxy groups contained in the polymer (B) (former/latter) is, for example, in a range from 0.1 to 10. A lower limit value of the molar ratio is preferably 0.5, more preferably 1, more preferably 2, even more preferably 3, still more preferably 4, particularly preferably 5, most preferably 6, and especially preferably 6.5. An upper limit value of the molar ratio is preferably 9, particularly preferably 8, most preferably 7.5, and especially preferably 7.

The content of the thermoplastic resin (C) is, for example, greater than or equal to 0.1 parts by weight, preferably greater than or equal to 0.5 parts by weight, particularly preferably greater than or equal to 0.8 parts by weight, most preferably greater than or equal to 1.0 part by weight, and especially preferably greater than or equal to 1.2 parts by weight, relative to 1 part by weight of the polymer (B) contained in the temporary adhesive. The content of the thermoplastic resin (C) is, for example, less than or equal to 3.0 parts by weight, and preferably less than or equal to 2.0 parts by weight relative to 1 part by weight of the polymer (B) contained in the temporary adhesive.

A weight ratio of a total content of the compound (A) and the polymer (B) to the content of the thermoplastic resin (C) contained in the temporary adhesive (former/latter) is, for example, from 65/35 to 35/65, preferably from 60/40 to 40/60, preferably from 55/45 to 40/60, and most preferably from 50/50 to 40/60.

A total content of the compound (A), the polymer (B) and the thermoplastic resin (C) is from 70 to 99.9 wt.%, preferably from 80 to 99 wt.%, particularly preferably from 85 to 95 wt.%, and most preferably from 85 to 93 wt.% based on the total amount of the non-volatile components of the temporary adhesive.

The temporary adhesive can further contain another component. Examples of the other component can include a reaction accelerator, an antioxidant, an acid generator, a surfactant, a solvent, a leveling agent, a silane coupling agent, and a foaming agent. These can be used alone or in combination of two or more.

The temporary adhesive can be prepared by stirring and mixing the components described above, and, if necessary, stirring and mixing them under vacuum while removing air bubbles. The temperature at the time of stirring and mixing is preferably about from 10 to 80°C. For stirring and mixing, a known or commonly used apparatus (such as a planetary centrifugal mixer, a single-screw or multi-screw extruder, a planetary mixer, a kneader, or a dissolver) can be used.

A viscosity, at 25°C and a shear rate of 50/s, of the temporary adhesive is, for example, from 30 to 2000 cP. From the viewpoint of excellent applicability, an upper limit value of the viscosity is preferably 1500 cP, particularly preferably 1200 cP, and most preferably 1000 cP. A lower limit value of the viscosity is preferably 100 cP, more preferably 200 cP, even more preferably 300 cP, particularly preferably 500 cP, and most preferably 600 cP.

Polyvalent vinyl ether compound (A)

The polyvalent vinyl ether compound (A) is a compound having two or more vinyl ether groups in one molecule and is represented, for example, by Formula (a) below.

[Chem. 1]

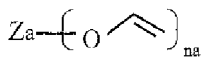

(a)

In Formula (a) above, $Z_a$ represents a group having a structural formula of a saturated or unsaturated aliphatic hydrocarbon, a saturated or unsaturated alicyclic hydrocarbon, an aromatic hydrocarbon, a heterocyclic compound, or a bound body in which two or more selected from these are bound via a single bond or a linking group, with $n_a$ hydrogen atoms removed.

In Formula (a) above, $n_a$ is an integer greater than or equal to 2, for example, an integer from 2 to 5 and preferably an integer of 2 or 3.

Among the groups having a structural formula of a saturated or unsaturated aliphatic hydrocarbon with $n_a$ hydrogen atoms removed, examples of a group having a structural formula of a saturated or unsaturated aliphatic hydrocarbon with two hydrogen atoms removed can include linear or branched alkylene groups (an alkylene group having from 1 to 20 carbons, and preferably an alkylene group having from 1 to 10 carbons) such as methylene, ethylene, propylene, trimethylene, tetramethylene, pentamethylene, hexamethylene, octamethylene, decamethylene, and dodecamethylene groups; and linear or branched alkenylene groups (an alkenylene group having from 2 to 20 carbons, preferably an alkenylene group having from 2 to 10 carbons) such as vinylene, 1-propenylene, and 3-methyl-2-butenylene groups. Examples of a group having a structural formula of a saturated or unsaturated aliphatic hydrocarbon with three hydrogen atoms removed can include a group having the structural formula of a saturated or unsaturated aliphatic hydrocarbon with two hydrogen atoms removed from which one hydrogen atom is further removed. The same applies to a group having a structural formula of a saturated or unsaturated aliphatic hydrocarbon with four or more hydrogen atoms removed.

Among the groups having a structural formula of a saturated or unsaturated alicyclic hydrocarbon with $n_a$ hydrogen atoms removed, examples of a group having a structural formula of the saturated or unsaturated alicyclic hydrocarbon with two hydrogen atoms removed can include cycloalkylene groups (3- to 15-membered cycloalkylene groups and the like) such as 1,2-cyclopentylene, 1,3-cyclopentylene, 1,2-cyclohexylene, 1,3-cyclohexylene, and 1,4-cyclohexylene group; cycloalkenylene groups (3- to 15-membered cycloalkenylene groups and the like) such as cyclopentenylene and cyclohexenylene groups; cycloalkylidene groups (3- to 15-membered cycloalkylidene groups and the like) such as cyclopentylidene and cyclohexylidene groups; and divalent bridged cyclic hydrocarbon groups (4- to 15-membered divalent bridged cyclic groups and the like) such as adamantanediyl, norbornanediyl, norbornanediyl, isobornanediyl, tricyclodecanediyl, tricycloundecanediyl, and tetracyclododecanediyl groups. Examples of a group having a structural formula of a saturated or unsaturated alicyclic hydrocarbon with three hydrogen atoms removed can include a group having a structural formula of the saturated or unsaturated alicyclic hydrocarbon with two hydrogen atoms removed and with one hydrogen atom further removed. The same applies to a group having a structural formula of a saturated or unsaturated alicyclic hydrocarbon with four or more hydrogen atoms removed.

Examples of the aromatic hydrocarbon can include benzene, naphthalene, and anthracene.

The heterocyclic compound includes an aromatic heterocyclic compound and a non-aromatic heterocyclic compound. Examples of such a heterocyclic compound can include heterocyclic compounds containing an oxygen atom as a heteroatom (for example, 5-membered rings, such as furan, tetrahydrofuran, oxazole, isooxazole, and γ-butyrolactone rings; 6-membered rings, such as 4-oxo-4H-pyran, tetrahydropyran, and morpholine rings; fused rings, such as benzofuran, isobenzofuran, 4-oxo-4H-chromene, chroman, and isochroman rings; and bridged rings, such as 3-oxatricyclo[4.3.1.1$^{4,8}$]undecane-2-one ring and a 3-oxatricyclo[4.2.1.0$^{4,8}$]nonane-2-one ring); heterocyclic compounds containing a sulfur atom as a heteroatom (for example, 5-membered rings, such as thiophene, thiazole, isothiazole, and thiadiazole rings; 6-membered rings, such as a 4-oxo-4H-thiopyran ring; and fused rings, such as a benzothiophene ring); and heterocyclic compounds containing a nitrogen atom as a heteroatom (for example, 5-membered rings, such as pyrrole, pyrrolidine, pyrazole, imidazole, and triazole rings; 6-membered rings, such as pyridine, pyridazine, pyrimidine, pyrazine, piperidine, and piperazine rings; and fused rings, such as indole, indoline, quinoline, acridine, naphthyridine, quinazoline, and purine rings).

Examples of the linking group can include di- to tetra-valent hydrocarbon groups, a carbonyl group (-CO-), an ether bond (-O-), a sulfide bond (-S-), an ester bond (-COO-), an amide bond (-CONH-), a carbonate bond (-OCOO-), a urethane bond (-NHCOO-), an -NR- bond (where R represents a hydrogen atom, an alkyl group, or an acyl group), and groups in which a plurality of these groups are linked. Among the di- to tetra-valent hydrocarbon groups, examples of the divalent hydrocarbon group can include linear or branched alkylene groups having from 1 to 10 carbons, such as methylene, methylmethylene, dimethylmethylene, ethylene, propylene, and trimethylene groups; and alicyclic hydrocarbon groups having from 4 to 15 carbons (in particular, cycloalkylene groups), such as 1,2-cyclopentylene, 1,3-cyclopentylene, cyclopentylidene, 1,2-cyclohexylene, 1,3-cyclohexylene, 1,4-cyclohexylene, and cyclohexylidene groups. Examples of the trivalent hydrocarbon group can include a group having a structural formula of the divalent hydrocarbon group with one hydrogen atom removed. Examples of the tetravalent hydrocarbon group can include a group having a structural formula of the divalent hydrocarbon group.

The $Z_a$ may have one or two or more substituents. Examples of the substituent can include an alkyl group (e.g., $C_{1-4}$ alkyl groups such as methyl and ethyl groups), a cycloalkyl group (e.g., $C_{3-10}$ cycloalkyl groups), an alkenyl group (e.g., $C_{2-10}$ alkenyl groups such as a vinyl group), a cycloalkenyl group (e.g., $C_{3-10}$ cycloalkenyl groups), an aryl group (e.g., $C_{6-15}$ aryl groups such as phenyl and naphthyl groups), a hydroxy group, a carboxy group, a nitro group, an amino group, a mercapto group, a halogen atom, $C_{2-10}$ hydrocarbon groups substituted with a halogen atom, hydrocarbon groups containing a functional group containing a hetero atom (e.g., oxygen and sulfur) (e.g., $C_{1-4}$ alkoxy groups and $C_{2-6}$ acyloxy groups), and a group with two or more of these groups bound.

Specific examples of the compound (A) can include 1,4-butanediol divinyl ether, diethylene glycol divinyl ether, triethylene glycol divinyl ether, and compounds represented by the following formulae.

[Chem. 2]

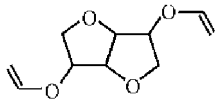
(a-1)

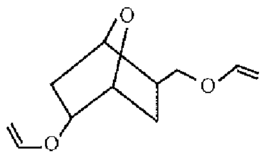
(a-2)

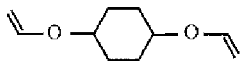
(a-3)

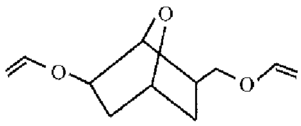
(a-4)

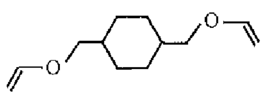
(a-5)

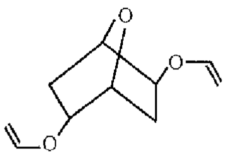
(a-6)

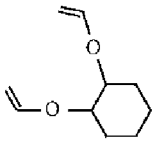
(a-7)

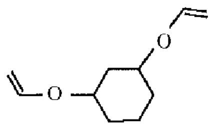
(a-8)

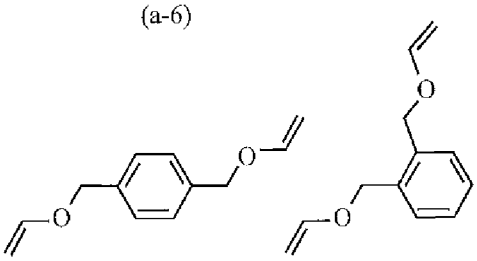
(a-9) (a-10)

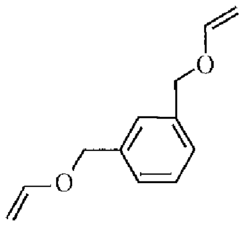
(a-11)

[Chem. 3]

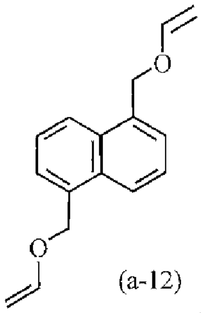
(a-12)

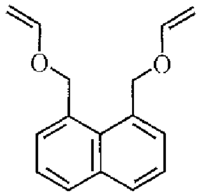
(a-13)

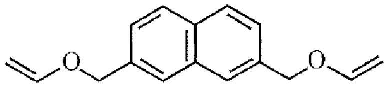
(a-14)

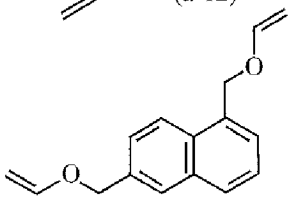
(a-15)

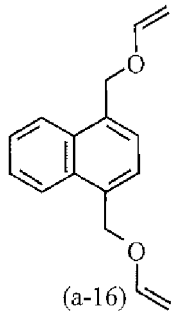
(a-16)

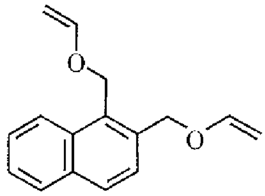
(a-17)

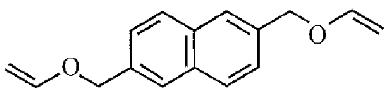
(a-18)

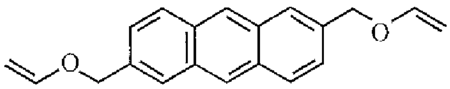
(a-19)

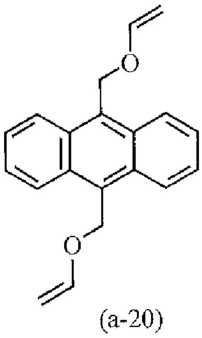
(a-20)

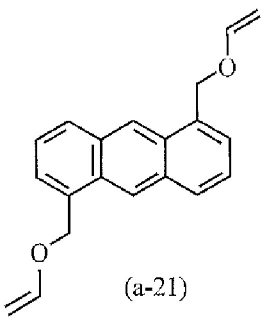
(a-21)

Among them, from the viewpoint that a crosslinked body having a high softening point can be formed, the $Z_a$ is preferably a saturated or unsaturated aliphatic hydrocarbon and a group having a structural formula in which these are bound via a linking group, with $n_a$ hydrogen atoms removed, particularly preferably a saturated aliphatic hydrocarbon or a group having a structural formula in which a saturated aliphatic hydrocarbon is bound via a linking group, with $n_a$ hydrogen atoms removed, and especially preferably a linear alkylene group having from 1 to 20 carbons, a branched alkylene group having from 2 to 20 carbons, or a group having a structural formula in which these are bound via a linking group, with $n_a$ hydrogen atoms removed.

The (A) is most preferably at least one compound selected from 1,4-butanediol divinyl ether, diethylene glycol divinyl ether, or triethylene glycol divinyl ether.

Polymer (B)

The polymer (B) is a polymer having a plurality of hydroxy groups and/or carboxy groups as pendant groups. The polymer (B) may have, as pendant groups, only hydroxy groups, only carboxy groups, or both hydroxy groups and carboxy groups.

Examples of the polymer (B) include a polymer or copolymer of a monomer having a hydroxy group and/or a carboxy group and having a vinyl-based polymerizable group. Specific examples of the polymer (B) include a styrene-based polymer, a (meth)acrylic polymer, polyvinyl alcohol, a novolac resin, and a resol resin.

The polymer (B) is, for example, a compound having two or more constituent units (repeating units) represented by Formula (b) below.

[Chem. 4]

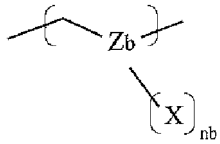

(b)

In Formula (b) above, X represents a hydroxy group or a carboxy group. In addition, $n_b$ X's may be the same or different.

In Formula (b) above, $n_b$ represents an integer greater than or equal to 1, preferably an integer from 1 to 3, and particularly preferably an integer of 1 or 2.

In Formula (b) above, $Z_b$ represents a group having a structural formula of a saturated or unsaturated aliphatic hydrocarbon, a saturated or unsaturated alicyclic hydrocarbon, an aromatic hydrocarbon, a heterocyclic compound, or a bound body in which two or more selected from these are bound via a single bond or a linking group, with ($n_d$ + 2) hydrogen atoms removed. Examples of the structural formula of the saturated or unsaturated aliphatic hydrocarbon, the saturated or unsaturated alicyclic hydrocarbon, the aromatic hydrocarbon, the heterocyclic compound, or the bound body in which these are bound via a single bond or a linking group can include the same examples as those for the $Z_a$.

As the constituent unit (repeating unit) represented by Formula (b) above, at least one constituent unit (repeating unit) selected from Formulae (b-1) to (b-6) below is preferable. That is, as the polymer (B), a compound having at least one constituent unit (repeating unit) selected from Formulae (b-1) to (b-6) below is preferable.

[Chem. 5]

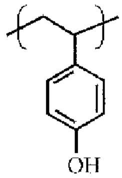

(b-1)

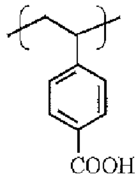

(b-2)

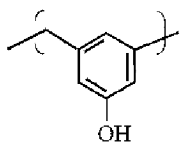

(b-3)

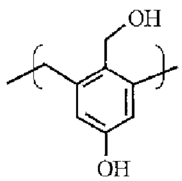

(b-4)

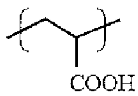

(b-5)

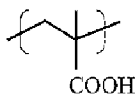

(b-6)

**In** the polymer (B), the number of repetitions of the constituent unit represented by Formula (b) above is 2 or greater, and is preferably from 2 to 40, particularly preferably from 10 to 30, and most preferably from 15 to 25, from the viewpoint that a crosslinked body having a high softening point can be formed by crosslinking the polymer (B) with the compound (A) and increasing the molecular weight.

When a compound in which X in Formula (b) is a hydroxy group is used as the polymer (B), a proportion of the constituent unit represented by Formula (b) in the total amount of the polymer (B) is preferably 30 wt.% or greater, particularly preferably 35 wt.% or greater, and most preferably 40 wt.% or greater. The proportion of the constituent unit represented by Formula (b) in the total amount of the polymer (B) is preferably 30 wt.% or greater, particularly preferably 35 wt.% or greater, and most preferably 40 wt.% or greater.

When a compound in which X in Formula (b) is a carboxy group is used as the polymer (B), the proportion of the constituent unit represented by Formula (b) in the total amount of the polymer (B) is preferably 1 wt.% or greater, particularly preferably 5 wt.% or greater, and most preferably 10 wt.% or greater.

When the proportion of the constituent unit represented by Formula (b) is less than the above range, the weight average molecular weight of the resulting crosslinked body tends to decrease and the softening point tends to decrease due to the extension of a distance between crosslinking points or the decrease in number of crosslinking points, thereby

making it difficult to provide the adhesion retention in a high temperature environment.

The polymer (B) may be a homopolymer having only the constituent unit represented by Formula (b), or a copolymer having the constituent unit represented by Formula (b) and another constituent unit. When the polymer (B) is a copolymer, it may be any of a block copolymer, a graft copolymer, and a random copolymer.

The other constituent unit is a constituent unit derived from a polymerizable monomer having neither a hydroxy group nor a carboxy group, and examples thereof can include an olefin [for example, a chain olefin such as ethylene, propylene, and 1-butene (particularly, a $C_{2-12}$ alkene); a cyclic olefin such as cyclopentene, cyclohexene, cycloheptene, norbornene, 5-methyl-2-norbornene, and tetracyclododecene (particularly, a $C_{3-10}$ cycloalkene)], an aromatic vinyl compound (for example, a $C_{7-14}$ aromatic vinyl compound such as styrene, vinyltoluene, $\alpha$-methylstyrene, 1-propenylbenzene, 1-vinylnaphthalene, 2-vinylnaphthalene, 3-vinylpyridine, 3-vinylfuran, 3-vinylthiophene, 3-vinylquinoline, indene, methylindene, ethylindene, and dimethylindene), an unsaturated carboxylic acid ester [for example, an ester produced by reacting an unsaturated carboxylic acid (for example, (meth)acrylic acid) and an alcohol (R"-OH, where R" represents a group having a structural formula of a saturated or unsaturated aliphatic hydrocarbon, a saturated or unsaturated alicyclic hydrocarbon, an aromatic hydrocarbon, a heterocyclic compound, or a bound body in which these are bound via a single bond or a linking group, with one hydrogen atom removed, and examples thereof can include a monovalent group corresponding to the example for $Z_a$ in Formula (a)), such as ethyl (meth)acrylate, butyl (meth)acrylate, isobutyl (meth)acrylate, 2-ethylhexyl (meth)acrylate, and dicyclopentanyl (meth)acrylate)], a carboxylic acid vinyl ester (for example, a $C_{1-16}$ fatty acid vinyl ester such as vinyl acetate, vinyl propionate, vinyl caprylate, and vinyl caproate), and an unsaturated dicarboxylic acid diester (for example, a maleic acid di-$C_{1-10}$ alkyl ester such as diethyl maleate, dibutyl maleate, dioctyl maleate, and 2-ethylhexyl maleate, and a fumaric acid diester corresponding to the alkyl ester). These can be used alone or in combination of two or more.

When the polymer (B) is a copolymer, the compound (B) is especially preferably a compound containing: the constituent unit represented by Formula (b) above; and a constituent unit derived from at least one polymerizable monomer selected from a chain olefin, a cyclic olefin, an aromatic vinyl compound, an unsaturated carboxylic acid ester, a carboxylic acid vinyl ester, or an unsaturated dicarboxylic acid diester.

The polymer (B) has a weight average molecular weight (calibrated with polystyrene, by a GPC method) from 1500 to 7000. A lower limit value of the weight average molecular weight is preferably 1800, particularly preferably 2000, most preferably 3000, and especially preferably 4000, from the viewpoint that the molecular weight is increased by crosslinking the polymer (B) with the compound (A) and thus a crosslinked body having a high softening point can be formed. **In** addition, an upper limit value of the weight average molecular weight is preferably 6000, and particularly preferably 5000, from the viewpoint of improving the fluidity of the temporary adhesive and facilitating application.

When the polymer (B) is a polymer having a constituent unit represented by Formula (b) above in which X is a hydroxy group, the hydroxyl value of the polymer (B) is, for example, from 50 to 500, preferably from 100 to 400, particularly preferably from 150 to 350, and most preferably from 200 to 300. The acid value is, for example, less than or equal to 1.

When the polymer (B) is a polymer having a constituent unit represented by Formula (b) in which X is a carboxy group, the acid value of the polymer (B) is, for example, from 50 to 500, preferably from 100 to 400, particularly preferably from 150 to 350, and most preferably from 200 to 300. The hydroxyl value is, for example, less than or equal to 1.

When the polymer (B) is a polymer having a constituent unit represented by Formula (b) above in which X is a hydroxy group and a constituent unit represented by Formula (b) in which X is a carboxy group, the hydroxyl value of the polymer (B) is, for example, from 50 to 300, preferably from 50 to 200, and particularly preferably from 50 to 150. The acid value is, for example, from 50 to 300, preferably from 50 to 200, and particularly preferably from 50 to 150.

Thermoplastic Resin (C)

Examples of the thermoplastic resin (C) can include polycondensation resins such as polyvinyl acetal resins, polyester resins, polyurethane resins, polyamide resins, poly(thio)ether-based resins, polycarbonate resins, polysulfone-based resins, and polyimide-based resins; vinyl polymerization resins such as polyolefin-based resins, (meth)acrylic resins, styrene-based resins, and vinyl-based resins; and resins derived from natural products such as cellulose derivatives. These can be used alone or in combination of two or more.

Since the temporary adhesive of the present disclosure contains the thermoplastic resin (C), a heat-treated product of the temporary adhesive has flexibility (or bendability), can prevent natural peeling or cracking even in an environment in which the temperature rapidly changes, and can retain excellent adhesiveness.

The thermoplastic resin (C) preferably contains at least one resin selected from a polyvinyl acetal resin, a polyester resin, a polyurethane resin, or a polyamide resin.

When the thermoplastic resin (C) contains at least a polyester resin, flexibility can be imparted to the heat-treated product, a chemical interaction with an adherend such as a wafer is small, and an adhesive remaining on the adherend after peeling can be more easily removed.

In addition, when the thermoplastic resin (C) contains a polyvinyl acetal resin and a polyester resin, flexibility can

be imparted to the heat-treated product, cohesiveness to the adherend is particularly excellent, and the adhesive remaining on the adherend after peeling can be more easily removed.

Further, the thermoplastic resin (C) may have a hydroxy group and/or a carboxy group. When the thermoplastic resin (C) has a hydroxy group and/or a carboxy group, these groups react with the compound (A), and the softening point of the heat-treated product is thus improved, and an effect of maintaining good adhesiveness in a high temperature environment is achieved.

The thermoplastic resin (C) has hydroxy groups, the hydroxyl value of the thermoplastic resin (C) is, for example, less than or equal to 300 (for example, from 5 to 300, preferably from 10 to 250, particularly from preferably 50 to 250, and most preferably from 100 to 250).

When the thermoplastic resin (C) has carboxy groups, the acid value of the thermoplastic resin (C) is, for example, less than or equal to 300 and less than or equal to 300 (for example, from 5 to 300, preferably from 10 to 250, particularly preferably from 50 to 250, and most preferably from 100 to 250).

When the thermoplastic resin (C) has hydroxy groups and carboxy groups, the hydroxyl value of the thermoplastic resin (C) is, for example, less than or equal to 200 (e.g. from 1 to 200, preferably from 10 to 150, and particularly preferably from 50 to 100). The acid value is, for example, less than or equal to 200 (e.g., from 1 to 200, preferably from 10 to 150, and particularly preferably from 50 to 100).

When the thermoplastic resin (C) has hydroxy groups and/or carboxy groups in excess of the above-mentioned range, slide peeling tends to be difficult.

The polyvinyl acetal resin is a resin containing a constituent unit produced by reacting polyvinyl alcohol with an aldehyde (RCHO: a compound in which R in the above formula is a hydrogen atom, a linear $C_{1-5}$ alkyl group, a branched $C_{2-5}$ alkyl group, or a $C_{6-10}$ aryl group, such as formaldehyde, butyraldehyde, or benzaldehyde), and examples thereof can include polyvinyl formal and polyvinyl butyral. As the polyvinyl acetal resin, commercially available products such as the trade names "S-LEC KS-1" and "S-LEC KS-10" (available from Sekisui Chemical Co., Ltd.) can be used.

Examples of a polyester-based resin can include polyesters produced by polycondensation of diol components (aliphatic $C_{2-12}$ diols such as ethylene glycol, polyoxy $C_{2-4}$ alkylene glycols such as diethylene glycol; alicyclic $C_{5-15}$ diols such as cyclohexanedimethanol; and aromatic $C_{6-20}$ diols such as bisphenol A) and dicarboxylic acid components (aromatic $C_{8-20}$ dicarboxylic acids such as terephthalic acid; aliphatic $C_{2-40}$ dicarboxylic acids such as adipic acid; and alicyclic $C_{8-15}$ dicarboxylic acids such as cyclohexanedicarboxylic acid); polyesters produced by polycondensation of oxycarboxylic acids (aliphatic $C_{2-6}$ oxycarboxylic acids such as lactic acid, and aromatic $C_{7-19}$ oxycarboxylic acids such as hydroxybenzoic acid); polyesters produced by ring-opening polymerization of lactones ($C_{4-12}$ lactones such as $\varepsilon$-caprolactone, $\delta$-valerolactone, and $\gamma$-butyrolactone); and polyesters containing urethane bonds produced by reaction of polyester diol and diisocyanate. The polyester-based resins include homopolyesters and copolyesters. In the present disclosure, a commercially available product such as the trade name "PLACCEL H1P" (available from Daicel Corporation) can be used.

In the temporary adhesive, it is preferable to use a thermoplastic resin (C) having a high softening point (when two or more thermoplastic resins (C) are used, at least one of the two or more thermoplastic resins (C) has a high softening point) from the viewpoint of maintaining good adhesiveness in a high temperature environment. In particular, when the temporary adhesive is used in combination with a permanent adhesive, it is preferable to use a thermoplastic resin (C) having a softening point higher than a thermosetting temperature of the permanent adhesive (for example, higher by 10°C or higher, and preferably higher by 20°C or higher) because good adhesiveness can be maintained during thermosetting of the permanent adhesive. The softening point of such a thermoplastic resin (C) is, for example, 150°C or higher, preferably 160°C or higher, particularly preferably 170°C or higher, most preferably 180°C or higher, and especially preferably 190°C or higher. An upper limit value of the softening point is, for example, 200°C.

The softening point of the thermoplastic resin (C) can be controlled by adjusting the weight average molecular weight. When the thermoplastic resin (C) has a weight average molecular weight (Mw: calibrated with polystyrene, by the GPC method) of greater than 7000 (preferably greater than or equal to 8000, more preferably greater than or equal to 8000, still more preferably greater than or equal to 10000, particularly preferably greater than or equal to 13000, and most preferably greater than or equal to 15000), it has a softening point higher than the thermosetting temperature of the permanent adhesive and can impart good adhesiveness in a high temperature environment.

In addition, the weight average molecular weight of the thermoplastic resin (C) is preferably less than or equal to 100000, more preferably less than or equal to 80000, particularly preferably less than or equal to 50000, most preferably less than or equal to 30000, and especially preferably less than or equal to 25000 from the viewpoint that good solubility in a solvent can be imparted to the heat-treated product.

Reaction Accelerator

Examples of the reaction accelerator can include a monovalent carboxylic acid represented by Formula (d) below and a monovalent alcohol represented by Formula (e) below. These can be used alone or in combination of two or more.

The temporary adhesive containing the compound is preferable in that the crosslinking reaction of the compound (A) and the polymer (B) can be accelerated, that a crosslinked body having an equivalent or higher softening point can be formed even when a crosslinking reaction temperature is lowered as compared with that in the case of using a temporary adhesive containing no reaction accelerator, and that the adhesiveness can be retained even in a higher temperature environment (for example, about from 160 to 180°C).

$Z_d$-COOH (d)

where $Z_d$ represents a group that may have a substituent other than a carboxy group, the group having a structural formula of one selected from the group consisting of saturated or unsaturated aliphatic hydrocarbons, saturated or unsaturated alicyclic hydrocarbons, and aromatic hydrocarbons, with one hydrogen atom removed.

$Z_e$-OH (e)

where $Z_e$ represents a group that may have a substituent other than a hydroxy group, the group having a structural formula of an aromatic hydrocarbon with one hydrogen atom removed.

Examples of the saturated or unsaturated aliphatic hydrocarbon, the saturated or unsaturated alicyclic hydrocarbon, and the aromatic hydrocarbon for $Z_d$ in Formula (d) above and the aromatic hydrocarbon for $Z_e$ in Formula (e) above can include monovalent groups corresponding to the above examples for the $Z_a$. Examples of the substituent which $Z_d$ may have can include the examples of the substituent which $Z_a$ may have, other than a carboxy group. Examples of the substituent which $Z_e$ may have can include the examples of the substituent which $Z_a$ may have, other than a hydroxy group.

The reaction accelerator preferably has a pKa (acid dissociation constant) from 3 to 8, and particularly preferably from 4 to 6. When the pKa is lower than the above range, storage stability tends to decrease. For example, the crosslinking reaction proceeds in the temporary adhesive, and the viscosity is increased. On the other hand, when the pKa exceeds the above range, the effect of accelerating the crosslinking reaction tends to decrease.

As the monovalent carboxylic acid represented by Formula (d), the following compounds (including geometric isomers) are preferable.

[Chem. 6]

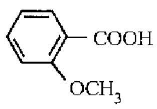 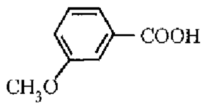 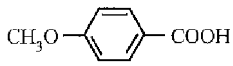

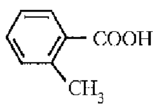 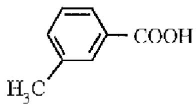 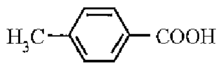

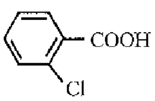 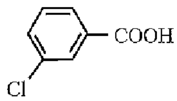 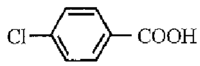

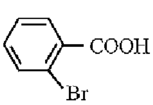 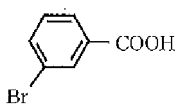 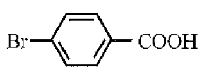

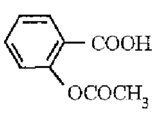 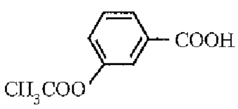 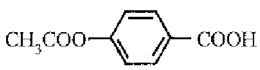

[Chem. 7]

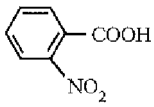
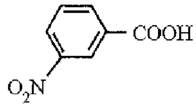
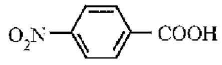
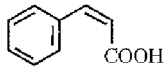
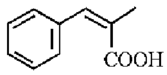
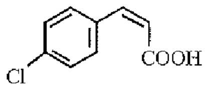
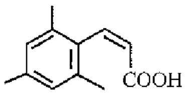
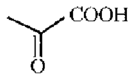
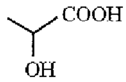
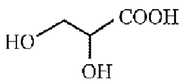
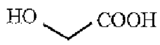
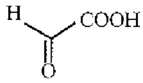
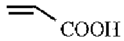
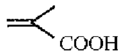
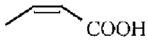

The monovalent alcohol represented by Formula (e) is preferably a compound which will be shown below.

[Chem. 8]

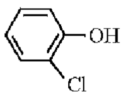
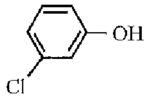
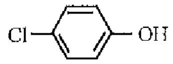
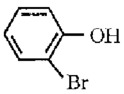
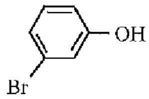
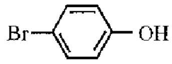
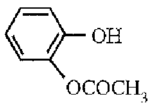
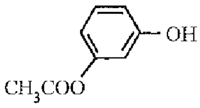
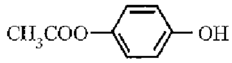
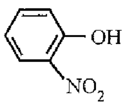
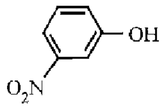
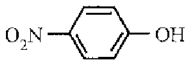
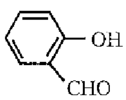
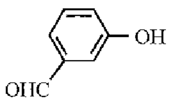
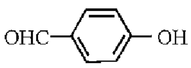
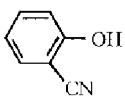
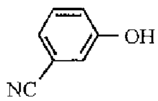
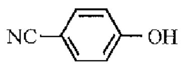
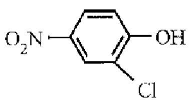
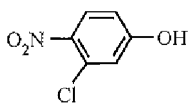

An amount of the reaction accelerator to be used is, for example, about from 0.01 to 5 parts by weight (preferably from 0.1 to 3 parts by weight, and particularly preferably from 0.3 to 1 part by weight) relative to 1 part by weight of the compound (A) contained in the temporary adhesive.

Antioxidant

When the temporary adhesive of the present disclosure contains an antioxidant, the polymer (B) and the thermoplastic resin (C) contained in the temporary adhesive can be prevented from being oxidized at the time of a heat treatment. This is preferable in that the solubility in a solvent of an adhesive residue generated at the time of performing thermal adhesion using the temporary adhesive and then performing slide peeling is improved and that the adhesive residue can be extremely easily removed by the solvent.

Examples of the antioxidant can include phenol-based antioxidants, phosphorus-based antioxidants, thioester-based antioxidants, and amine-based antioxidants. These can be used alone or in combination of two or more. As the antioxidant, it is preferable to use a phenol-based antioxidant from the viewpoint of a particularly excellent effect of preventing oxidation caused by a heat treatment.

Examples of the phenol-based antioxidant can include pentaerythritol tetrakis[3(3,5-di-t-butyl-4-hydroxyphenyl) propionate], thiodiethylene bis[3-(3,5-di-t-butyl-4-hydroxyphenyl)propionate], octadecyl 3-(3,5-di-t-butyl-4-hydroxyphenyl) propionate, N,N'-hexamethylenebis[3-(3,5-di-t-butyl-4-hydroxyphenyl)propionamide], octyl 3-(4-hydroxy-3,5-diisopropylphenyl)propionate, 1,3,5-tris(4-hydroxy-3,5-di-t-butylbenzyl)-2,4,6-trimethylbenzene, 2,4-bis(dodecylthiomethyl)-6-methylphenol, and calcium bis[3,5-di(t-butyl)-4-hydroxybenzyl(ethoxy)phosphinate]. As the phenol-based antioxidants, for example, commercially available products such as the trade names "Irganox 1010", "Irganox 1035", "Irganox 1076", "Irganox 1098", "Irganox 1135", "Irganox 1330", "Irganox 1726", and "Irganox 1425WL" (all available from BASF) can be used.

An amount of the antioxidant to be used (or content; when two or more antioxidants are contained, a total amount thereof) is, for example, from 0.01 to 15 parts by weight (preferably from 0.1 to 12 parts by weight, and particularly preferably from 0.5 to 10 parts by weight) relative to 100 parts by weight of a total of the polymer (B) and the thermoplastic resin (C).

Surfactant

Examples of a surfactant can include products under the trade names "F-444", "F-447", "F-554", "F-556", and "F-557" (all are fluorine oligomers available from DIC Corporation), a product under the trade name "BYK-350" (an acrylic polymer available from BYK), and products under the trade names "A-1420", "A-1620", and "A-1630" (all are fluorine-containing alcohols available from Daikin Industries, Ltd.). These can be used alone or in combination of two or more.

When the surfactant is added to the temporary adhesive in an amount of about from 0.01 to 1 wt.% based on the total amount of the temporary adhesive, cissing at the time of applying the temporary adhesive can be improved, and uniformity of the coating film can be improved.

Solvent

Examples of the solvent can include hydrocarbon solvents such as toluene and hexane; alcohol-based solvent such as isopropanol; ketone-based solvents such as methyl isobutyl ketone, cyclopentanone, and cyclohexanone; glycol ester-based solvents such as propylene glycol monomethyl ether acetate; glycol ether-based solvents such as propylene glycol monomethyl ether; and ester-based solvents such as γ-butyrolactone. These can be used alone or in combination of two or more. The solvent is preferably a solvent that easily volatilizes at a temperature lower than a thermal polymerization initiation temperature of the temporary adhesive (for example, a temperature lower than 230°C), and particularly preferably a ketone-based solvent.

When the solvent is added to the temporary adhesive, the viscosity of the temporary adhesive can be lowered and the applicability can be improved.

An amount of the solvent to be added is, for example, from 1 to 10 times by weight of the content of the resin components. From the viewpoint of providing excellent peelability, the amount is preferably from 1 to 5 times by weight, particularly preferably from 1 to 4 times by weight, and most preferably from 2 to 3 times by weight.

When the solvent is used in slide peeling, the amount of the solvent to be added is preferably 2 to 10 times by weight, particularly preferably 2 to 5 times by weight, and most preferably 2 to 4 times by weight, from the viewpoint of providing excellent peelability.

When the solvent is used in blade peeling, the amount of the solvent to be added is preferably from 1 to 5 times by weight, particularly preferably from 1 to 4 times by weight, and most preferably from 1 to 2 times by weight, from the viewpoint of providing excellent peelability.

Acid Generator

The temporary adhesive may further contain an acid generator. The acid generator includes a photoacid

generator and a thermal acid generator.

When the temporary adhesive contains the acid generator, an acid generated from the acid generator exhibits an action of decomposing a binding portion between the compound (A) and the polymer (B) contained in the heat-treated product of the temporary adhesive and reducing the molecular weight. Therefore, the viscosity of the heat-treated product of the temporary adhesive can be lowered at a low temperature as compared with that in the case where the acid generator is not contained, and the slide peeling becomes possible. In addition, the adhesive residue can be more easily washed.

A content of the acid generator (amount thereof to be blended) is, for example, from 0.01 to 0.1 parts by weight relative to 1 part by weight of the compound (A).

Method for Manufacturing Semiconductor Wafer Laminate

The method for manufacturing a semiconductor wafer laminate of the present disclosure is a method for manufacturing a semiconductor wafer laminate using the temporary adhesive, and includes a method for forming a semiconductor wafer laminate through the following steps [1] to [5] and a method for forming a semiconductor wafer laminate through the following steps [1] to [4] and [6]:

[1] applying the temporary adhesive as described above to at least one of a first semiconductor wafer or a support, and bonding the first semiconductor wafer and the support to each other, thereby forming a laminate 1 having a structure [first semiconductor wafer/temporary adhesive/support];
[2] heating the laminate 1, and allowing a crosslinking reaction of resin components in the temporary adhesive to proceed until a weight average molecular weight of the resin components increases by more than or equal to 1.2 times, thereby forming a laminate 2 having a structure [first semiconductor wafer/temporary adhesive layer/support];
[3] processing the first semiconductor wafer of the laminate 2, thereby forming a laminate 3 having a structure [processed first semiconductor wafer/temporary adhesive layer/support];
[4] bonding a second semiconductor wafer to the laminate 3 via a permanent adhesive, and curing the permanent adhesive, thereby forming a laminate 4 having a structure [second semiconductor wafer/permanent adhesive layer/processed first semiconductor wafer/temporary adhesive layer/support];
[5] heating the laminate 4 until a viscosity, at a frequency of 10 Hz, of the temporary adhesive layer reaches less than or equal to 100 cP, and slide-peeling off the support, thereby forming a semiconductor wafer laminate having a structure [second semiconductor wafer/permanent adhesive layer/processed first semiconductor wafer]; and
[6] in an atmosphere at a temperature lower than or equal to 30°C, inserting a blade into a gap between the processed first semiconductor wafer and the support of the laminate 4, and peeling off the support, thereby forming a semiconductor wafer laminate having a structure [second semiconductor wafer/permanent adhesive layer/processed first semiconductor wafer].

Step [1]

The step [1] is a step of applying the temporary adhesive as described above to at least one of a first semiconductor wafer or a support, and bonding the first semiconductor wafer and the support to each other, thereby forming a laminate 1.

The semiconductor wafer is a thin plate made of a crystal of a semiconductor material such as silicon. The first semiconductor wafer is one of a plurality of semiconductor wafers forming a semiconductor wafer laminate.

The support is used for fixing the first semiconductor wafer when processing such as thinning is performed on the first semiconductor wafer, and any support can be used without particular limitation as long as it can exhibit the above-described action.

The temporary adhesive may be applied to one or both of the first semiconductor wafer and the support.

As a method of applying the temporary adhesive, for example, a well-known and commonly used method such as curtain coating, squeegee coating, roll coating, spray coating, brush coating, bar coating, roller coating, silk screen printing, or spin coating can be adopted.

An application thickness of the temporary adhesive is, for example, from about 1 to 20 $\mu$m.

The temporary adhesive has a low viscosity at 25°C. Therefore, it is excellent in applicability and can be applied with a uniform thickness.

When the temporary adhesive contains a solvent, it is preferable that the solvent be removed by drying the temporary adhesive after application thereof. Examples of the drying method include a method in which heating and drying are performed at a temperature from 120 to 250°C using a hot plate or the like.

After the temporary adhesive is applied and dried if necessary, the first semiconductor wafer and the support are bonded to each other with a surface to which the temporary adhesive is applied facing inward. As a result, the laminate 1 having a structure [first semiconductor wafer/temporary adhesive/support] is formed.

The bonding is preferably performed in a temperature environment in which the crosslinking reaction of the temporary adhesive does not proceed (for example, in an environment at a temperature lower than or equal to 150°C, preferably in an environment of a temperature from 100 to 150°C) from the viewpoint that the bonding can be performed while positional deviation is adjusted.

Step [2]

The step [2] is a step of heating the laminate 1 formed through the step [1], and allowing a crosslinking reaction of resin components to proceed until a weight average molecular weight of the resin components in the temporary adhesive increases by more than or equal to 1.2 times, i.e., until the temporary adhesive becomes the heat-treated product, thereby forming a laminate 2 having a structure [first semiconductor wafer/temporary adhesive layer/support].

The heating temperature is, for example, higher than 150°C and lower than or equal to 250°C, preferably from 180 to 250°C, and particularly preferably from 200 to 250°C. The heating may be performed in a state where the temperature is fixed at a constant level in the temperature range, or may be performed while the temperature is changed stepwise. The heating time is, for example, about from 30 seconds to 30 minutes, and preferably from 3 minutes to 12 minutes. When the heating temperature and the heating time are lower than the above ranges, the weight average molecular weight of the resulting crosslinked body is low and the softening point is low, and thus the adhesion retention in a high temperature environment tends to be lowered. On the other hand, when the heating temperature and the heating time exceed the above-mentioned ranges, the softening point of the resulting crosslinked body may be lowered due to the occurrence of side reactions, or the softening point may become too high due to excessive crosslinking, and the washability after peeling may be lowered, which is not preferable from the viewpoint of lowering of productivity.

In addition, it is preferable to perform the heat treatment while pressing the first semiconductor wafer and the support at an appropriate pressure (for example, about from 300 to 5000 g/cm$^2$) from the viewpoint that the first semiconductor wafer and the support can be strongly adhered (or fixed).

The heat treatment can be performed either in the air or in vacuum.

When the temporary adhesive is subjected to a heat treatment, a crosslinking reaction in which the vinyl ether group of the compound (A) reacts with a hydroxy group and/or a carboxy group of the polymer (B) proceeds. As a result, the polymer (B) in the temporary adhesive is crosslinked by the compound (A), and the molecular weight is increased.

For example, when a temporary adhesive containing a compound represented by Formula (a') below as the compound (A) and containing a compound having a constituent unit represented by Formula (b-1) below as the compound (B) is subjected to a heat treatment, a crosslinked body represented by Formula (1) below is produced.

[Chem. 9]

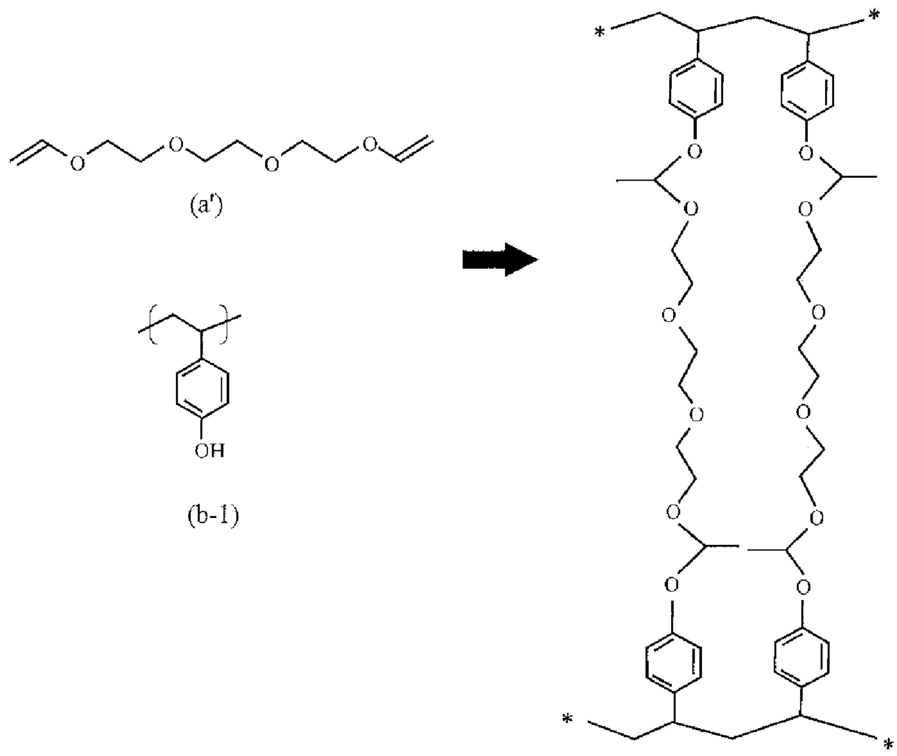

(a')

(b-1)

(1)

The crosslinked body is, for example, a thermoplastic resin having a softening point higher than 130°C (for example, from 130 to 170°C, and particularly preferably from 140 to 160°C).

In the temporary adhesive after the heat treatment (this is a "temporary adhesive layer" constituting the laminate 2), the compound (A) and the polymer (B) form a crosslinked body, and thus the molecular weight of the resin components is increased. Therefore, even when the laminate 2 is subjected to processing in a high temperature environment (for example, a high temperature environment at a temperature higher than or equal to 100°C and lower than 130°C), such as processing on the first semiconductor wafer in the step [3] or curing of the permanent adhesive in the step [4], the laminate 2 has sufficient adhesiveness to firmly adhere (or fix) the first semiconductor wafer to the support.

Step [3]

The step [3] is a step of processing the first semiconductor wafer of the laminate 2 formed through the step [2], thereby forming a laminate 3 having a structure [processed first semiconductor wafer/temporary adhesive layer/support].

Examples of the processing on the first semiconductor wafer include grinding (thinning) and etching. Therefore, the processed first semiconductor wafer is, for example, a first semiconductor wafer subjected to grinding (thinning), etching, or the like.

Step [4]

The step [4] is a step of bonding a second semiconductor wafer to the laminate 3 formed through the step [3] via a permanent adhesive, and curing the permanent adhesive, thereby forming a laminate 4 having a structure [second semiconductor wafer/permanent adhesive layer/processed first semiconductor wafer/temporary adhesive layer/support].

The permanent adhesive is preferably a permanent adhesive that is thermally cured at a temperature lower than 200°C. Examples of such a permanent adhesive include an epoxy-based adhesive, a phenol formaldehyde-based adhesive, a polyvinyl butyral-based adhesive, a cyanoacrylate-based adhesive, a rubber-based adhesive, a styrene/-butadiene-based adhesive, an acrylic adhesive, a vinyl acetate-based adhesive, and a silicone-based adhesive.

Examples of the method for bonding the second semiconductor wafer to the laminate 3 via the permanent adhesive include a method in which the permanent adhesive is applied to a surface of the second semiconductor wafer, and then the surface to which the permanent adhesive is applied is bonded to the processed first semiconductor wafer side

of the laminate 3.

The surface of the second semiconductor wafer may be subjected to a surface treatment. For example, when the surface treatment is performed with a silane coupling agent or the like, an effect of improving the adhesiveness by the permanent adhesive can be obtained.

Since the temporary adhesive layer contains a crosslinked body of the compound (A) and the polymer (B), the adhesiveness can be maintained even in a high temperature environment at a temperature lower than the softening point of the crosslinked body. In addition, since the heat-treated product of the temporary adhesive is excellent in flexibility, the occurrence of natural peeling or cracking is suppressed even in an environment in which the temperature rapidly changes. Therefore, it is possible to thermally cure the permanent adhesive while maintaining adhesion (or fixation) between the processed first semiconductor wafer and the support.

Step [5]

The step [5] is a step of forming a semiconductor wafer laminate by slide peeling. More specifically, this is a step of heating the laminate 4 formed through the step [4] until a viscosity, at a frequency of 10 Hz, of the temporary adhesive layer reaches less than or equal to 100 cP, and slide-peeling off the support from the laminate 4, thereby forming a semiconductor wafer laminate having a structure [second semiconductor wafer/permanent adhesive layer/processed first semiconductor wafer].

The temporary adhesive layer contains a crosslinked body of the compound (A) and the polymer (B), and the crosslinked body has thermoplasticity. Therefore, the viscosity can be lowered by performing a heat treatment. Regarding a degree of viscosity reduction, the viscosity at a frequency of 10 Hz is, for example, less than or equal to 100 cP, and is preferably less than or equal to 70 cP, particularly preferably less than or equal to 50 cP, and most preferably less than or equal to 30 cP because the risk of damage during peeling can be reduced.

The heat treatment temperature is a temperature higher than or equal to the softening point of the crosslinked body, for example, higher than or equal to 200°C. In addition, the temperature is preferably from 200 to 240°C, and particularly preferably from 200 to 235°C, from the viewpoint of easy removal of an adhesive residue after peeling. When the heat treatment temperature exceeds the above range, the resin contained in the temporary adhesive layer is easily oxidized, and, due to the oxidation of the resin, it tends to be difficult to remove the adhesive residue by washing.

In addition, in the case where the temporary adhesive contains an acid generator, when an acid is generated by heat treatment or light irradiation after crosslinking, the crosslinked body is decomposed at a crosslinked portion and the molecular weight is reduced. Therefore, the heat treatment temperature can be set to a lower temperature, and oxidation of the resin can be further suppressed.

When a photoacid generator is contained as the acid generator, light irradiation is preferably performed before the heat treatment. As the light, light rays having various wavelengths (for example, ultraviolet rays and X-rays) can be used. Among them, far ultraviolet light having a wavelength less than or equal to 400 nm is preferably used. A light irradiation energy is, for example, about from 500 to 8000 mJ/cm$^2$. The heating temperature of the heat treatment performed after the light irradiation is, for example, about from 50 to 160°C, preferably from 100 to 150°C. The heating time is, for example, about from 30 seconds to 30 minutes, and preferably from 3 minutes to 5 minutes.

When a thermal acid generator is contained as the acid generator, the heating temperature of the heat treatment is, for example, about from 50 to 160°C, and preferably from 100 to 150°C. The heating time is, for example, about from 30 seconds to 15 minutes, and preferably 3 minutes to 5 minutes.

When the viscosity of the temporary adhesive layer is lowered, the adhesiveness is rapidly lowered or lost. Therefore, after the viscosity is lowered, application of a lateral stress to the support portion of the laminate 4 can slide the support and separate it from the [second semiconductor wafer/permanent adhesive layer/processed first semiconductor wafer].

When an adhesive residue is present after the support is slide-peeled off, the adhesive residue can be easily removed by performing a washing treatment with a solvent. Examples of the solvent include cyclohexanone, propylene glycol monomethyl ether, propylene glycol monomethyl ether acetate, acetone, ethyl acetate, butyl acetate, and methyl isobutyl ketone. These can be used alone or in combination of two or more.

Step [6]

Step [6] is a step of forming a semiconductor wafer laminate by blade peeling. More specifically, this is a step of, in an atmosphere at a temperature lower than or equal to 30°C, inserting a blade into a gap between the processed first semiconductor wafer and the support of the laminate 4 formed through the step [4], and peeling off the support, thereby forming a semiconductor wafer laminate having a structure [second semiconductor wafer/permanent adhesive layer/-processed first semiconductor wafer].

In the laminate 4 having a structure [second semiconductor wafer/permanent adhesive layer/processed first

semiconductor wafer/temporary adhesive layer/support], the temporary adhesive layer is composed of a heat-treated product having a Tg higher than or equal to 100°C and lower than 200°C. Therefore, the temporary adhesive layer is a glassy solid in an atmosphere at a temperature lower than or equal to 30°C, and, by inserting a blade into a gap between the first semiconductor wafer and the support, the [temporary adhesive layer/support] portion can be easily peeled off by a mechanical method. Thus, a semiconductor wafer laminate can be collected without damage.

The configurations and their combinations of the present disclosure described above are merely an example, and addition, omission, substitution, and modification of the configurations may be appropriately made without departing from the gist of the present disclosure. In addition, the present disclosure is not limited by the embodiments and is limited only by the claims.

## Examples

The present disclosure will next be described in more detail by way of Examples, but the present disclosure is not limited to the Examples.

A spin coater (trade name "ACT-400AII", available from Active, Ltd.) was used for application of the temporary adhesive.

A hot plate (ND-1, available from AS ONE Corporation) was used for heating.

### Example 1

### Preparation of Temporary Adhesive

Components were blended according to the formulation (in parts by weight) shown in the following Table 1 and mixed, resulting in the formation of a composition (A-1). In the composition (A-1), the molar ratio of the vinyl ether group contained in the compound (A) to the total of the hydroxy groups and the carboxy groups contained in the polymer (B) (former/latter) was 6.6.

### Production of Temporary Adhesive Layer (A-1)

The resulting composition (A-1) was spin-coated on a silicon substrate (diameter: 100 mm, thickness: 500 μm), and a coating film was formed. The coating film was heated at 200°C for 2 minutes and then at 230°C for 4 minutes, and thus dried, and the molecular weight of the resin components in the coating film was increased. Next, this was heated at 230°C for 5 minutes, and the molecular weight of the resin components was further increased, resulting in the formation of a temporary adhesive layer (A-1)/silicon substrate laminate.

### Examples 2 and 3

Compositions (A-2) and (A-3) were formed in the same manner as in Example 1 (preparation of temporary adhesive) except that the amount of CHO (cyclohexanone) added was changed as shown in Table 1 below. In the compositions (A-2) and (A-3), the molar ratio of the vinyl ether group contained in the compound (A) to the total of the hydroxy groups and the carboxy groups contained in the polymer (B) (former/latter) was 6.6.

[Table 1]

Table 1

| | | Example 1 Composition (A-1) | Example 2 Composition (A-2) | Example 3 Composition (A-3) |
|---|---|---|---|---|
| Compound (A) | TEGDVE | 6.66 | 6.66 | 6.66 |
| Polymer (B) | CST-50 | 100 | 100 | 100 |
| Thermoplastic resin (C) | KS-10 | 100 | 100 | 100 |
| | PCL H-1P | 50 | 50 | 50 |

(continued)

| | | Example 1 Composition (A-1) | Example 2 Composition (A-2) | Example 3 Composition (A-3) |
|---|---|---|---|---|
| Other | In1010 | 20 | 20 | 20 |
| | t-CA | 5 | 5 | 5 |
| | F-554 | 1.25 | 1.25 | 1.25 |
| | CHO | 611 | 484 | 1132 |

Abbreviations in the table are described below.

Compound (A)

TEGDVE: triethylene glycol divinyl ether

Polymer (B)

CST-50: p-hydroxystyrene/styrene copolymer (molar ratio: 50/50, weight ratio: 46/54), weight average molecular weight (calibrated with polystyrene, by the GPC method): 4400, hydroxyl value: 237, acid value: 0.1, softening point: 150°C, trade name "Maruka Linker CST-50", available from Maruzen Petrochemical Co., Ltd.

Thermoplastic resin (C)

KS-10: polyvinyl butyral resin, molecular weight: $1.7 \times 10^4$, softening point: 200°C, hydroxyl value: 137, acid value: 0.3, trade name "S-LEC KS-10", available from Sekisui Chemical Co., Ltd.
PCL H-1P: polycaprolactone, weight average molecular weight (calibrated with polystyrene, by the GPC method): 10000, softening point: 100°C, hydroxyl value: 12, acid value: 0.5, trade name "PLACCEL H1P", available from Daicel Corporation

Other

In1010: pentaerythritol tetrakis(3-(3,5-di-t-butyl-4-hydroxyphenyl)propionate), phenol-based antioxidant, trade name "Irganox 1010", available from BASF
T-CA: trans cinnamic acid, reaction accelerator, pKa: 4.44, available from Wako Pure Chemical Industries, Ltd.
F-554: fluorine-based oligomer, surfactant, trade name "F-554", available from DIC Corporation.
CHO: cyclohexanone, solvent
The acid values and hydroxyl values of the polymer (B) and the thermoplastic resin (C) were measured by the following methods.

Acid Value

Measuring apparatus: potentiometric titrator "AT-500N" available from Kyoto Electronics Manufacturing Co., Ltd.
Electrode: glass electrode "C-173", available from Kyoto Electronics Manufacturing Co., Ltd.

Titrant: 0.1 mol/L alcoholic KOH solution
Mixed solvent: toluene/methanol (V/V) = 4/1

Procedure

The sample and the mixed solution (80 mL) were added to a 100-mL Erlenmeyer flask, dissolved, and titrated. A blank test was also performed in the same manner, and the acid value was calculated from the following equation.

$$\text{Acid value (mgKOH/g)} = (V_1 - V_0) \times N \times 56.11 \times f/S$$

S: weight (g) of collected sample

$V_0$: amount (mL) of the titrant required in the blank test
$V_1$: amount (mL) of the titrant required in the main test
N: concentration of the titrant (0.1 mol/L)
f: factor of the titrant (1.008)

Hydroxyl Value

Measuring apparatus: potentiometric titrator "AT-500N" available from Kyoto Electronics Manufacturing Co., Ltd.
Electrode: glass electrode "C-173", available from Kyoto Electronics Manufacturing Co., Ltd.
Titrant: 0.5 mol/L alcoholic KOH solution
Acetylating agent: Acetic acid anhydride (20 g) is taken in a flask, pyridine is added thereto, and the volume is made constant at 100 mL.

Procedure

The sample was weighed in a 200-mL Erlenmeyer flask, and 5 mL of an acetylating agent was added thereto, followed by reaction in an oil bath at 100°C ± 5°C for 1 hour. After allowing to cool, 1 mL of water was added, and the mixture was reacted in the oil bath at 100°C ± 5°C for 10 minutes. After allowing to cool, washing was performed with 5 mL of ethanol, and 100 mL of pyridine was added thereto for dilution. Titration was performed using the potentiometric titrator, and the resulting inflection point was taken as the end point. A blank test was carried out in the same manner, and the hydroxyl value was calculated from the following equation.

$$\text{Hydroxyl value (mgKOH/g)} = (V_0 - V_1) \times N \times 56.11 \times f/S + \text{acid value}$$

S: weight (g) of collected sample
$V_0$: amount (mL) of the titrant required in the blank test
$V_1$: amount (mL) of the titrant required in the main test
N: concentration of the titrant (0.5 mol/L)
f: factor of the titrant (0.999)

The weight average molecular weight, molecular weight distribution, viscosity, Tg, and softening point of the composition (A-1) and the temporary adhesive layer (A-1) formed in Example 1 were measured by the following methods. The results are collectively shown in Table 2.

Measurement of Weight Average Molecular Weight and Molecular Weight Distribution

The weight average molecular weight (Mw; calibrated with polystyrene) and the molecular weight distribution (Mw/Mn) were determined by GPC measurement.

GPC apparatus: Shimadzu GPC system
Eluent: Tetrahydrofuran
Separation column: KF-602, KF-603, KFG-4A
Measurement temperature: 40°C
Detector: Shodex RI-504
Flow rate: 0.6 mL/min
Data processing system: CBM-20A

Measurement of Viscosity

Regarding the viscosity of the composition (A-1), a shear viscosity at 25°C and a shear rate of 50/s was calculated using a rheometer (trade name "Rheometer MCR301", available from AntonPaar).
The viscosity of the temporary adhesive layer (A-1) was measured for a sample produced by the following method using a rheometer under the following conditions.

Sample production method:

0.5 g of the composition (A-1) was poured into an aluminum pan, and heated at 140°C for 30 minutes and then at

200°C for 10 minutes, and the coating film of the composition was dried. Then, it was heated at 230°C for 5 minutes, and the molecular weight of the resin components in the coating film was increased, thereby producing a temporary adhesive layer (A-1) having a thickness of 0.5 mm.

Measurement conditions

Temperature: from 200 to 250°C
Rate of temperature increase: 10°C/min
Atmosphere: $N_2$
Frequency: 10 Hz
Measuring tool: 25 φ disposable
Apparatus used: melt viscoelasticity measuring apparatus (MCR-302/available from AntonPaar)
Measurement method: dynamic measurement

Tg

Only the temporary adhesive layer (A-1) was scraped off from the temporary adhesive layer (A-1)/silicon substrate laminate, and the Tg of the temporary adhesive layer (A-1) was measured using DSC under the following conditions.

Measurement apparatus: differential scanning calorimetry (DSC-7000X, available from Hitachi High-Tech Science Corporation)

Atmosphere: $N_2$
Temperature range: from 0 to 250°C
Rate of temperature increase: 20°C/min

Softening Point

With respect to the [silicon substrate (1)/temporary adhesive layer (A-1)/silicon substrate (2)] laminate formed by the following preparation method, in a state where the silicon substrate (2) was fixed, the silicon substrate (1) was pulled horizontally by applying a 2-kg stress while heating, and the temperature at which the silicon substrate (1) started to move was determined and defined as the softening point.

Method for Preparing [Silicon Substrate (1)/Temporary Adhesive Layer (A-1)/Silicon Substrate (2)] Laminate

The composition (A-1) was spin-coated on the silicon substrate (1) (diameter: 100 mm, thickness: 500 μm), and a coating film was formed. The coating film was heated at 200°C for 2 minutes and then at 230°C for 4 minutes, and thus dried, and the molecular weight of the resin components in the coating film was increased. Next, the silicon substrate (2) (diameter: 100 mm, thickness: 500 μm) was bonded. Heating was performed at 230°C for 5 minutes, and the molecular weight of the resin components was further increased, resulting in the formation of a [silicon substrate (1)/temporary adhesive layer (A-1)/silicon substrate (2)] laminate.

[Table 2]

Table 2

| | Composition (A-1) | Temporary adhesive layer (A-1) |
|---|---|---|
| Mw | 11600 | 14800 |
| Mw/Mn | 13.9 | 5.3 |
| Viscosity at room temperature | 800 cP | - |

(continued)

| | Composition (A-1) | Temporary adhesive layer (A-1) |
|---|---|---|
| Viscosity at 200°C | - | 30 cP |
| Tg | - | 113.8°C |
| Softening point | - | 130°C |

The compositions (A-1) to (A-3) formed in Examples 1 to 3 were evaluated as follows. The results are presented in Table 3.

Production of Semiconductor Wafer Laminate

First, the compositions formed in Examples were each spin-coated on a silicon substrate (diameter: 300 mm, thickness: 775 μm) as a support, and a coating film was formed. The coating film was heated at 200°C for 2 minutes and then at 230°C for 4 minutes, and thus dried. The molecular weight of the resin components in the composition was increased, resulting in the formation of a [silicon substrate (support)/coating film] laminate.

Next, a silicon wafer (diameter: 300 mm, thickness: 775 μm) was bonded to the [silicon substrate (support)/coating film] laminate at a temperature of 130°C while being pressurized under the condition of a pressure of 1500 g/cm$^2$. Thereafter, the resin components were further increased in molecular weight by heating at 230°C for 5 minutes, thereby producing a semiconductor wafer laminate having a structure [silicon substrate (support)/temporary adhesive layer/silicon wafer].

Measurement of Film Thickness

The thickness of the coating film of the [silicon substrate (support)/coating film] laminate was determined by measuring the film thickness at the wafer center and at a position of every 10 mm from the wafer center using a non-contact type step profiler, and calculating an average value of these values.

Evaluation of Applicability

Regarding the applicability of the compositions formed in Examples, when the values calculated from Formulae (1) and (2) below were less than ±3%, the applicability was evaluated as good, and when the values were ±3% or greater, the applicability was evaluated as poor.

{(Average value of thickness of coating film excluding portion within 2 mm from edge) - (minimum film thickness) }/(average value of thickness of coating film excluding portion within 2 mm from edge) × 100 (%)     Formula (1)

{(Maximum film thickness) - (average value of thickness of coating film excluding portion within 2 mm from edge) }/(average value of thickness of coating film excluding portion within 2 mm from edge) × 100 (%)     Formula (2)

Evaluation of Slide Peelability

The semiconductor wafer laminate [silicon substrate (support)/temporary adhesive layer/silicon wafer] was subjected to a heat treatment at 235°C for 5 minutes, and then the silicon substrate (support) was slid and removed from the silicon wafer, and the peelability was evaluated based on the following criteria.

Good slide peelability: peelable at a rate greater than or equal to 1 mm/sec
Poor slide peelability: peelable at a rate less than 1 mm/sec or unpeelable

Evaluation of Blade Peelability

At 23°C, a blade was inserted into a gap between the silicon substrate (support) and the silicon wafer of the semiconductor wafer laminate [silicon substrate (support)/temporary adhesive layer/silicon wafer], and the silicon substrate (support) was removed from the silicon wafer. The peelability was evaluated based on the following criteria.

Good blade peelability: peelable at a rate greater than or equal to 0.5 mm/sec
Poor blade peelability: peelable at a rate of less than 0.5 mm/sec or unpeelable

Evaluation of Washability

After the silicon substrate (support) was peeled off from the semiconductor wafer laminate [silicon substrate (support)/temporary adhesive layer/silicon wafer], an adhesive residue was washed with PGME, the presence or absence of a washing residue was visually confirmed, and the washability was evaluated based on the following criteria.

Good washability: washing residue is absent
Poor washability: washing residue is present

[Table 3]

Table 3

| | | Example 1 | Example 2 | Example 3 |
|---|---|---|---|---|
| Film thickness (μm) | | 9.9 | 20 | 1.9 |
| Application uniformity (%) | | ± 1.4 | ± 0.8 | ± 1.6 |
| Applicability | | Good | Good | Good |
| Slide peeling | Peeling rate (mm/sec) | 10 | 1 | 2 |
| | Peelability | Good | Good | Good |
| Blade peeling | Peeling rate (mm/sec) | 1 | 2 | 0.5 |
| | Peeling characteristic | Good | Good | Good |
| Washability | | Good | Good | Good |

To summarize the above, configurations and variations of the present disclosure are additionally described below.

[Supplementary Note 1] A composition containing, as resin components, a polyvalent vinyl ether compound (A), a polymer (B) having a plurality of hydroxy groups and/or carboxy groups as pendant groups, and a thermoplastic resin (C), wherein

the polymer (B) has a weight average molecular weight (calibrated with polystyrene by a GPC method) from 1500 to 7000,
the thermoplastic resin (C) has a weight average molecular weight (calibrated with polystyrene by the GPC method) greater than 7000,
the resin components contained in the composition have a weight average molecular weight less than 100000,
a weight average molecular weight of the resin components contained in a heat-treated product formed by heating the composition at 230°C for 5 minutes is more than or equal to 1.2 times as great as the weight average molecular weight of the resin components contained in the composition,
the heat-treated product has a Tg higher than or equal to 100°C and lower than 200°C, and
the heat-treated product has a viscosity, at 200°C and a frequency of 10 Hz, less than or equal to 100 cP.

[Supplementary Note 2] The composition according to [Supplementary Note 1], wherein the polyvalent vinyl ether compound (A) is represented by Formula (a) below:

[Chem. 10]

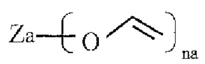

(a)

where $Z_a$ represents a group having a structural formula of a saturated aliphatic hydrocarbon or a structural formula of a

bound body in which two or more saturated aliphatic hydrocarbons are bound via a linking group, with $n_a$ hydrogen atoms removed, and $n_a$ represents an integer greater than or equal to 2.

[Supplementary Note 3] The composition according to [Supplementary Note 1], wherein the polyvalent vinyl ether compound (A) is at least one compound selected from 1,4-butanediol divinyl ether, diethylene glycol divinyl ether, or triethylene glycol divinyl ether.

[Supplementary Note 4] The composition according to any one of [Supplementary Note 1] to [Supplementary Note 3], wherein the polymer (B) is a compound having two or more constituent units represented by Formula (b):

[Chem. 11]

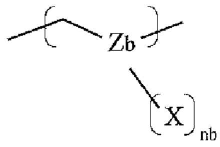

(b)

where X represents a hydroxy group or a carboxy group, $n_b$ is an integer greater than or equal to 1, and $Z_b$ represents a group having a structural formula of a saturated or unsaturated aliphatic hydrocarbon, a saturated or unsaturated alicyclic hydrocarbon, an aromatic hydrocarbon, a heterocyclic compound, or a bound body in which two or more selected from these are bound via a single bond or a linking group, with ($n_d$ + 2) hydrogen atoms removed.

[Supplementary Note 5] The composition according to any one of [Supplementary Note 1] to [Supplementary Note 3], wherein the polymer (B) is a compound having at least one constituent unit selected from Formulae (b-1) to (b-6).

[Supplementary Note 6] The composition according to any one of [Supplementary Note 1] to [Supplementary Note 3], wherein the polymer (B) is a compound having greater than or equal to 30 wt.% of a constituent unit represented by Formula (b1):

[Chem. 12]

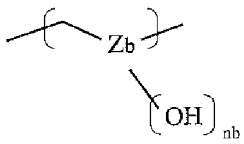

(b1)

where $n_b$ is an integer greater than or equal to 1, and $Z_b$ represents a group having a structural formula of a saturated or unsaturated aliphatic hydrocarbon, a saturated or unsaturated alicyclic hydrocarbon, an aromatic hydrocarbon, a heterocyclic compound, or a bound body in which two or more selected from these are bound via a single bond or a linking group, with ($n_d$ + 2) hydrogen atoms removed.

[Supplementary Note 7] The composition according to [Supplementary Note 6], wherein the polymer (B) has a hydroxyl value from 50 to 500.

[Supplementary Note 8] The composition according to any one of [Supplementary Note 1] to [Supplementary Note 3], wherein the polymer (B) is a compound having greater than or equal to 1 wt.% of a constituent unit represented by Formula (b2):

[Chem. 13]

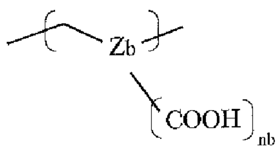

(b2)

where $n_b$ is an integer greater than or equal to 1, and $Z_b$ represents a group having a structural formula of a saturated or unsaturated aliphatic hydrocarbon, a saturated or unsaturated alicyclic hydrocarbon, an aromatic hydrocarbon, a heterocyclic compound, or a bound body in which two or more selected from these are bound via a single bond or a linking group, with ($n_d$ + 2) hydrogen atoms removed.

[Supplementary Note 9] The composition according to [Supplementary Note 8], wherein the polymer (B) has an acid value from 50 to 500.

[Supplementary Note 10] The composition according to any one of [Supplementary Note 1] to [Supplementary Note 3], wherein the polymer (B) is a compound having constituent units represented by Formulae (b1) and (b2):

[Chem. 14]

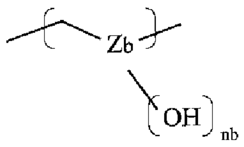

(b1)

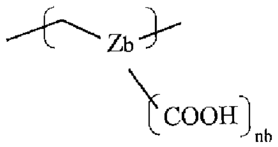

(b2)

where $n_b$'s are the same or different, and each represent an integer greater than or equal to 1, and $Z_b$'s are the same or different, and each represent a group having a structural formula of a saturated or unsaturated aliphatic hydrocarbon, a saturated or unsaturated alicyclic hydrocarbon, an aromatic hydrocarbon, a heterocyclic compound, or a bound body in which two or more selected from these are bound via a single bond or a linking group, with ($n_d$ + 2) hydrogen atoms removed.

[Supplementary Note 11] The composition according to [Supplementary Note 10], wherein the polymer (B) has a hydroxyl value from 50 to 300 and an acid value from 50 to 300.

[Supplementary Note 12] The composition according to any one of [Supplementary Note 1] to [Supplementary Note 11], wherein the thermoplastic resin (C) contains at least one resin selected from a polyvinyl acetal resin, a polyester resin, a polyurethane resin, or a polyamide resin.

[Supplementary Note 13] The composition according to any one of [Supplementary Note 1] to [Supplementary Note 12], wherein the thermoplastic resin (C) has a hydroxyl value from 5 to 300.

[Supplementary Note 14] The composition according to any one of [Supplementary Note 1] to [Supplementary Note 13], wherein the thermoplastic resin (C) has an acid value from 1 to 200.

[Supplementary Note 15] The composition according to any one of [Supplementary Note 1] to [Supplementary Note 14], wherein the composition contains the polyvalent vinyl ether compound (A) and the polymer (B) such that a molar ratio of a vinyl ether group contained in the polyvalent vinyl ether compound (A) to a total of the hydroxy groups and the carboxy groups contained in the (B) (former/latter) is in a range from 0.1 to 10.

[Supplementary Note 16] The composition according to any one of [Supplementary Note 1] to [Supplementary Note 15], wherein a content of the polyvalent vinyl ether compound (A) is from 0.5 to 10 wt.% based on a total amount of non-volatile components of the composition.

[Supplementary Note 17] The composition according to any one of [Supplementary Note 1] to [Supplementary Note 16], wherein a content of the polymer (B) is from 5 to 60 wt.% based on the total amount of the non-volatile components of the composition.

[Supplementary Note 18] The composition according to any one of [Supplementary Note 1] to [Supplementary Note 17], wherein a content of the thermoplastic resin (C) is from 35 to 70 wt.% based on the total amount of the non-volatile components of the composition.

[Supplementary Note 19] The composition according to any one of [Supplementary Note 1] to [Supplementary Note 18], wherein the content of the thermoplastic resin (C) is greater than or equal to 0.1 parts by weight and less than or equal to 3.0 parts by weight relative to 1 part by weight of the (B).

[Supplementary Note 20] The composition according to any one of [Supplementary Note 1] to [Supplementary Note 19], wherein a weight ratio [((A) + (B))/(C)] of a total content of the polyvalent vinyl ether compound (A) and the polymer (B) to the content of the thermoplastic resin (C) is from 65/35 to 35/65.

[Supplementary Note 21] The composition according to any one of [Supplementary Note 1] to [Supplementary Note 20], wherein a total content of the polyvalent vinyl ether compound (A), the polymer (B), and the thermoplastic resin (C) is from 70 to 99.9 wt.% based on the total amount of the non-volatile components of the composition.

[Supplementary Note 22] The composition according to any one of [Supplementary Note 1] to [Supplementary Note 22]

Note 21], wherein a viscosity at 25°C and a shear rate of 50/s is from 30 to 2000 cP.

[Supplementary Note 23] The composition according to any one of [Supplementary Note 1] to [Supplementary Note 22], further containing a monovalent carboxylic acid represented by Formula (d) or a monovalent alcohol represented by Formula (e):

$$Z_d\text{-COOH} \qquad (d)$$

where $Z_d$ represents a group that may have a substituent other than a carboxy group, the group having a structural formula of one selected from the group consisting of saturated or unsaturated aliphatic hydrocarbons, saturated or unsaturated alicyclic hydrocarbons, and aromatic hydrocarbons, with one hydrogen atom removed,

$$Z_e\text{-OH} \qquad (e)$$

where $Z_e$ represents a group that may have a substituent other than a hyroxy group, the group having a structural formula of an aromatic hydrocarbon, with one hydrogen atom removed.

[Supplementary Note 24] The composition according to [Supplementary Note 23], wherein a pKa of the monovalent carboxylic acid represented by Formula (d) and a pKa of the monovalent alcohol represented by Formula (e) are from 3 to 8.

[Supplementary Note 25] The composition according to [Supplementary Note 23] or [Supplementary Note 24], wherein a content of the monovalent carboxylic acid represented by Formula (d) or the monovalent alcohol represented by Formula (e) is from 0.01 to 5 parts by weight relative to 1 part by weight of the (A).

[Supplementary Note 26] The composition according to any one of [Supplementary Note 1] to [Supplementary Note 25], wherein the composition is a temporary adhesive.

[Supplementary Note 27] Use of the composition according to any one of [Supplementary Note 1] to [Supplementary Note 25] as a temporary adhesive.

[Supplementary Note 28] A method for manufacturing a semiconductor wafer laminate, the semiconductor wafer laminate being formed through [1] to [5] or [1] to [4] and [6], and the method including:

[1] applying the composition described in any one of [Supplementary Note 1] to [Supplementary Note 25] as a temporary adhesive to at least one of a first semiconductor wafer or a support, and bonding the first semiconductor wafer and the support to each other, thereby forming a laminate 1 having a structure [first semiconductor wafer/temporary adhesive/support];

[2] heating the laminate 1, and allowing a crosslinking reaction of resin components in the temporary adhesive to proceed until a weight average molecular weight of the resin components increases by more than or equal to 1.2 times, thereby forming a laminate 2 having a structure [first semiconductor wafer/temporary adhesive layer/support];

[3] processing the first semiconductor wafer of the laminate 2, thereby forming a laminate 3 having a structure [processed first semiconductor wafer/temporary adhesive layer/support];

[4] bonding a second semiconductor wafer to the laminate 3 via a permanent adhesive, and curing the permanent adhesive, thereby forming a laminate 4 having a structure [second semiconductor wafer/permanent adhesive layer/processed first semiconductor wafer/temporary adhesive layer/support];

[5] heating the laminate 4 until a viscosity, at a frequency of 10 Hz, of the temporary adhesive layer reaches less than or equal to 100 cP, and slide-peeling off the support, thereby forming a semiconductor wafer laminate having a structure [second semiconductor wafer/permanent adhesive layer/processed first semiconductor wafer]; and

[6] in an atmosphere at a temperature lower than or equal to 30°C, inserting a blade into a gap between the processed first semiconductor wafer and the support of the laminate 4, and peeling off the support, thereby forming a semiconductor wafer laminate having a structure [second semiconductor wafer/permanent adhesive layer/processed first semiconductor wafer].

[Supplementary Note 29] A method for manufacturing a temporary adhesive, the temporary adhesive having the following properties, the method including:

blending, as resin components, a polyvalent vinyl ether compound (A), a polymer (B) having a plurality of hydroxy groups and/or carboxy groups as pendant groups and having a weight average molecular weight (calibrated with polystyrene by a GPC method) from 1500 to 7000, and a thermoplastic resin (C) having a weight average molecular weight (calibrated with polystyrene by the GPC method) greater than 7000; and

adjusting a weight average molecular weight of the resin components to be blended to less than or equal to 100000:

properties: a weight average molecular weight of the resin components contained in a heat-treated product

formed by heating the temporary adhesive at 230°C for 5 minutes is more than or equal to 1.2 times as great as the weight average molecular weight of the resin components contained in the temporary adhesive before heating,
the heat-treated product has a Tg higher than or equal to 100°C and lower than 200°C, and
the heat-treated product has a viscosity, at 200°C and a frequency of 10 Hz, of less than or equal to 100 cP.

Industrial Applicability

The temporary adhesive of the present disclosure has good applicability at room temperature. A heat-treated product formed by subjecting the temporary adhesive to a heat treatment exhibits excellent adhesiveness even in a high temperature environment.
Further, the heat-treated product does not have tackiness in a temperature environment at a temperature lower than or equal to 30°C. Therefore, an adherend can be easily peeled off from a support by a blade peeling method.
Further, when the heat-treated product is heated at a temperature higher than or equal to 200°C, an adherend can be easily peeled off from a support by a slide peeling method.
Therefore, the temporary adhesive of the present disclosure can be suitably used as an adhesive for temporarily fixing a fragile adherend.

## Claims

1. A temporary adhesive comprising, as resin components, a polyvalent vinyl ether compound (A), a polymer (B) having a plurality of hydroxy groups and/or carboxy groups as pendant groups, and a thermoplastic resin (C), wherein

    the polymer (B) has a weight average molecular weight (calibrated with polystyrene by a GPC method) from 1500 to 7000,
    the thermoplastic resin (C) has a weight average molecular weight (calibrated with polystyrene by the GPC method) greater than 7000,
    the resin components contained in the temporary adhesive have a weight average molecular weight less than or equal to 100000,
    a weight average molecular weight of the resin components contained in a heat-treated product formed by heating the temporary adhesive at 230°C for 5 minutes is more than or equal to 1.2 times as great as the weight average molecular weight of the resin components contained in the temporary adhesive,
    the heat-treated product has a Tg higher than or equal to 100°C and lower than 200°C, and
    the heat-treated product has a viscosity, at 200°C and a frequency of 10 Hz, less than or equal to 100 cP.

2. The temporary adhesive according to claim 1, wherein the temporary adhesive contains the polyvalent vinyl ether compound (A) and the polymer (B) such that a molar ratio of a vinyl ether group contained in the polyvalent vinyl ether compound (A) to a total of the hydroxy groups and the carboxy groups contained in the polymer (B) (former/latter) is in a range from 0.1 to 10.

3. A method for manufacturing a semiconductor wafer laminate, the semiconductor wafer laminate being formed through [1] to [5] or [1] to [4] and [6], and the method comprising:

    [1] applying the temporary adhesive described in claim 1 or 2 to at least one of a first semiconductor wafer or a support, and bonding the first semiconductor wafer and the support to each other, thereby forming a laminate 1 having a structure [first semiconductor wafer/temporary adhesive/support];
    [2] heating the laminate 1, and allowing a crosslinking reaction of resin components in the temporary adhesive to proceed until a weight average molecular weight of the resin components increases by more than or equal to 1.2 times, thereby forming a laminate 2 having a structure [first semiconductor wafer/temporary adhesive layer/support];
    [3] processing the first semiconductor wafer of the laminate 2, thereby forming a laminate 3 having a structure [processed first semiconductor wafer/temporary adhesive layer/support];
    [4] bonding a second semiconductor wafer to the laminate 3 via a permanent adhesive, and curing the permanent adhesive, thereby forming a laminate 4 having a structure [second semiconductor wafer/permanent adhesive layer/processed first semiconductor wafer/temporary adhesive layer/support];
    [5] heating the laminate 4 until a viscosity, at a frequency of 10 Hz, of the temporary adhesive layer reaches less than or equal to 100 cP, and slide-peeling off the support, thereby forming a semiconductor wafer laminate having

a structure [second semiconductor wafer/permanent adhesive layer/processed first semiconductor wafer]; and [6] in an atmosphere at a temperature lower than or equal to 30°C, inserting a blade into a gap between the processed first semiconductor wafer and the support of the laminate 4, and peeling off the support, thereby forming a semiconductor wafer laminate having a structure [second semiconductor wafer/permanent adhesive layer/processed first semiconductor wafer].

# INTERNATIONAL SEARCH REPORT

International application No.
**PCT/JP2023/010737**

**A. CLASSIFICATION OF SUBJECT MATTER**

***C09J 4/00***(2006.01)i; ***C09J 201/06***(2006.01)i; ***H01L 21/02***(2006.01)i
FI: C09J4/00; C09J201/06; H01L21/02 B; H01L21/02 C

According to International Patent Classification (IPC) or to both national classification and IPC

**B. FIELDS SEARCHED**

Minimum documentation searched (classification system followed by classification symbols)

C09J4/00; C09J201/06; H01L21/02

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | WO 2017/061416 A1 (DAICEL CORP.) 13 April 2017 (2017-04-13) examples | 1-3 |
| X | WO 2020/085257 A1 (DAICEL CORP.) 30 April 2020 (2020-04-30) examples | 1-3 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **29 May 2023** | **06 June 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

**INTERNATIONAL SEARCH REPORT**
**Information on patent family members**

International application No.
**PCT/JP2023/010737**

| Patent document cited in search report | Publication date (day/month/year) | Patent family member(s) | Publication date (day/month/year) |
|---|---|---|---|
| WO 2017/061416 A1 | 13 April 2017 | US 2019/0119534 A1<br>examples<br>EP 3360939 A1<br>CN 108137994 A<br>KR 10-2018-0067514 A | |
| WO 2020/085257 A1 | 30 April 2020 | US 2021/0384184 A1<br>examples<br>CN 112913015 A<br>KR 10-2021-0081380 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2022049032 A
- JP 2008049443 A
- WO 2021112070 A